Europäisches Patentamt

European Patent Office

Office européen des brevets

(11) Veröffentlichungsnummer : **0 060 325**
**B1**

(12) **EUROPÄISCHE PATENTSCHRIFT**

(45) Veröffentlichungstag der Patentschrift :
13.06.84

(51) Int. Cl.³ : **H 03 H 11/20, H 03 H 11/04**

(21) Anmeldenummer : **81108733.7**

(22) Anmeldetag : **22.10.81**

(54) Schaltung zur Umwandlung einer oberschwingungsbehafteten Eingangsgrösse innerhalb eines bestimmten Frequenzbereiches in eine in der Phase und/oder Amplitude einstellbare sinusförmige Ausgangsgrösse.

(30) Priorität : **12.03.81 DE 3109522**

(43) Veröffentlichungstag der Anmeldung :
**22.09.82 Patentblatt 82/38**

(45) Bekanntmachung des Hinweises auf die Patenterteilung : **13.06.84 Patentblatt 84/24**

(84) Benannte Vertragsstaaten :
**BE CH FR GB LI NL SE**

(56) Entgegenhaltungen :
**FR-A- 2 428 943**
**GB-A- 1 572 478**

(73) Patentinhaber : **SIEMENS AKTIENGESELLSCHAFT**
**Berlin und München Wittelsbacherplatz 2**
**D-8000 München 2 (DE)**

(72) Erfinder : **Kaufhold, Wolfgang, Dipl.-Ing.**
**Lannersberg 15**
**D-8520 Erlangen (DE)**
Erfinder : **Ott, Günther, Dipl.-Ing.**
**Friedrich-Bauer-Strasse 1**
**D-8520 Erlangen (DE)**

**Beschreibung**

Die Erfindung bezieht sich auf eine Schaltung zur Umwandlung einer oberschwingungsbehafteten Eingangsgröße in eine sinusförmige Ausgangsgröße nach dem Oberbegriff des Anspruchs 1, die beispielsweise zur Simulierung von umrichtergespeisten Asynchronmaschinen vorgesehen ist.

Bei den üblichen Filterschaltungen höherer Ordnung zur Unterdrückung von Oberschwingungen einer Eingangsgröße tritt ein störender Phasengang für die gefilterte Ausgangsgröße auf, der umso größer wird, je stärker die Unterdrückung der Oberschwingungen getrieben wird und/oder je kleiner die Frequenzabstände innerhalb einer Oktave zwischen Ober- und Grundschwingung sind.

Bei Eingangsgrößen in Mehrphasensystemen kann für eine konstante Frequenz der Grundschwingung der Phasengang scheinbar dadurch beseitigt werden, daß der Filterphasengang entsprechend den Phasenverschiebungen der mehrphasigen Eingangsgröße gewählt wird und die verschiedenphasigen Ausgänge der Filterschaltung zyklisch vertauscht werden. Bei einphasigen Meßgrößen ist dies nicht möglich.

Der Erfindung liegt die Aufgabe zugrunde, eine praktisch vollständige Eliminierung der Oberschwingungen in einem bestimmten Frequenzbereich zu erzielen und eine oberwellenfreie sinusförmige Ausgangsgröße mit einstellbarer, insbesondere gleicher Amplitude und/oder Phase wie die Eingangsgröße über den Frequenzbereich zu erhalten.

Die Lösung der gestellten Aufgabe gelingt durch die Maßnahmen nach dem Kennzeichen des Anspruchs 1.

Dabei wird der Phasengang des eingangsseitigen Tiefpaß-Filters in üblicher Art ausgemessen und seine Ausgangsgröße frequenzabhängig kontinuierlich durch Anpassung der Amplitude und durch eine bestimmte Phasenverschiebung so korrigiert, daß am Ausgang der Schaltung als korrigierte Ausgangsgröße allein die Grundschwingung mit gewünschter, im Frequenzbereich gleichbleibender Amplitude und/oder Phase bezüglich der Grundschwingung der Eingangsgröße erscheint. Hierbei verwendete Vektoridentifizierer sind z. B. aus Siemens Forsch.- u. Entwickl. Ber., Band 6 (1977), Seiten 29 bis 38 bekannt.

In der Zeichnung ist ein Ausführungsbeispiel der Schaltung schematisch dargestellt und nachfolgend erläutert. Es zeigt

Figur 1 ein Blockschaltbild mit dem durch Pfeile gekennzeichneten Signalfluß,

Figur 2 bis 5 die Ortskurven der jeweiligen Frequenzgänge verschiedener Schaltungselemente.

Um aus einer mit Oberschwingungen behafteten beliebigen Eingangsgröße

$$E = \hat{U}_0 \sin \omega_0 t + \sum_{i=1}^{n} \hat{U}_i \sin \omega_i \tau$$

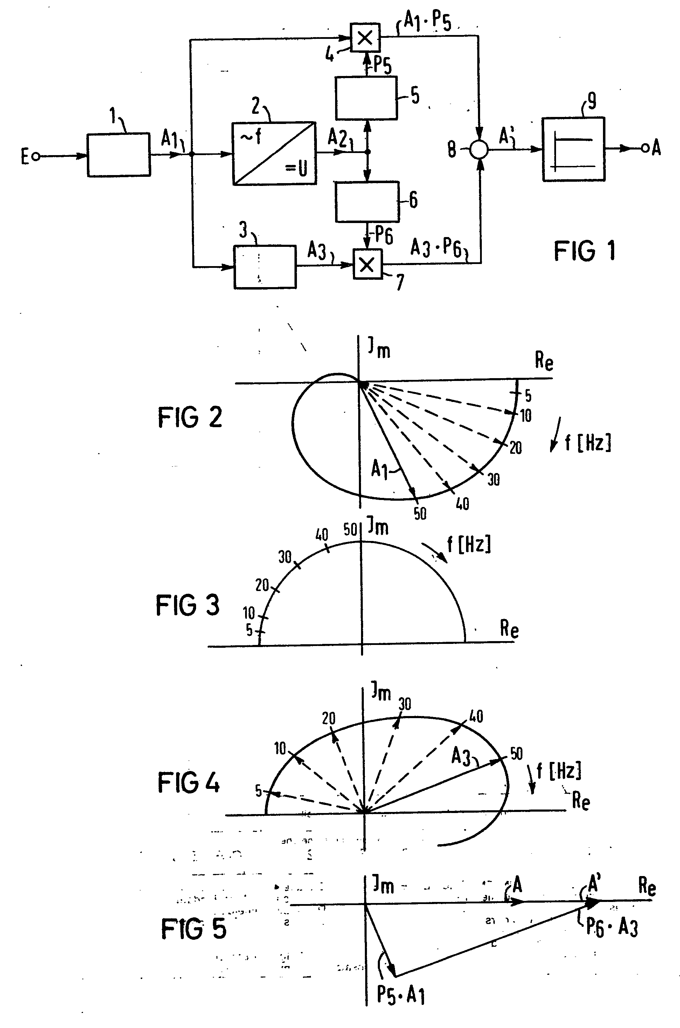

eine praktisch sinusförmige Ausgangsgröße $A = \hat{U}_0 \sin \omega_0 t$ zu erhalten, wird entsprechend Fig. 1 die Eingangsgröße E einem üblichen Tiefpaß-Filter 1 höherer Ordnung mit der in Fig. 2 gezeigten Frequenzgang-Ortskurve (Abszisse = reeller, Ordinate = imaginärer Anteil) zugeleitet. Die Ausgangsgröße $A_1$ des Tiefpaß-Filters 1 enthält innerhalb des betreffenden Frequenzganges nur noch die Grundschwingung, jedoch mit abweichender Amplitude und Phasenlage entsprechend der Ortskurve nach Fig. 2. Im Beispiel ist dabei auf eine Frequenz f = 50 Hz der Eingangsgröße E abgestellt, wie die vollausgezogenen Pfeile in den Ortskurven nach Fig. 2 bis 5 zeigen. Bei anderen Frequenzen (gestrichelte Pfeile) ergeben sich entsprechend andere Werte für die Amplitude und die Phase sowie die Korrekturgrößen.

Die Ausgangsgröße $A_1$ des Tiefpaß-Filters 1 mit der Ortskurve nach Fig. 2 wird gleichzeitig gemäß Fig. 1 unmittelbar auf Eingänge eines Frequenz-Spannungs-Umsetzers 2, eines phasenverschiebenden Vektoridentifizierers 3 mit der Ortskurve nach Fig. 3 sowie eines ersten Multiplizierers 4 gegeben und im Frequenz-Spannungs-Umsetzer 2 in eine frequenzproportionale ausgangsseitige Gleichspannung $A_2$ umgewandelt, die den Eingängen von einstellbaren Funktionsgeneratoren 5 und 6 zur Umwandlung in entsprechend den Phasenverschiebungen notwendige ausgangsseitige Gleichspannungsgrößen $P_5$, $P_6$ zugeführt wird. Die Gleichspannungsgröße $P_5$ wird im ersten Multiplizierer 4 mit der Ausgangsgröße $A_1$ (Fig. 1 und 2) multipliziert und ergibt gemäß Ortskurve nach Fig. 5 das gerichtete Produkt $A_1 \cdot P_5$, das dem Summierglied 8 zugeführt wird. Die andere Gleichspannungsgröße $P_6$ wird in einem zweiten Multiplizierer 7 mit der sich aus den Ortskurven Fig. 2 und Fig. 3 bestimmenden Ortskurve nach Fig. 4 gegebenen Ausgangsgröße $A_3$ des Vektoridentifizierers 3 multipliziert und das gerichtete Produkt $A_3 \cdot P_6$ nach Fig. 5 ebenfalls dem Summierglied 8 zugeführt, an dessen Ausgang gemäß Fig. 5 die geometrische Summe $A'$ beider Produkte auftritt, die über ein Proportionalglied als Anpassungsglied 9 in die phasengleiche und amplitudengleiche Ausgangsgröße $A = U_0 \sin \omega t$ umgewandelt wird.

Bei anderer Einstellung der Funktionsgeneratoren 5, 6 können abweichende Gleichspannungsgrößen $P_5$, $P_6$ erhalten werden, so daß die resultierenden Größen $A'$ und A in der Phase und/oder Amplitude in vorbestimmbarer Weise von der Grundschwingung der Eingangsgröße E abweichen.

Bei Umwandlung mehrerer Wechselgrößen gleicher Grundfrequenz werden entsprechend viele Filter, Vektoridentifizierer, Multiplizierer und Summierglieder mit nachgeschalteten Proportionalgliedern aber nur ein Umsetzer mit zwei nachgeordneten Funktionsgeneratoren benötigt.

# 0 060 325

## Ansprüche

1. Schaltung zur Umwandlung einer oberschwingungsbehafteten Eingangsgröße (E) innerhalb eines bestimmten Frequenzbereiches in eine in der Phase und/oder Amplitude einstellbare sinusförmige Ausgangsgröße (A), dadurch gekennzeichnet, daß die Eingangsgröße (E) einem üblichen Tiefpaß-Filter (1) zugeführt ist, der ausgangsseitig mit den Eingängen eines Frequenz-Spannungs-Umsetzers (2), eines phasenverschiebenden Vektoridentifizierers (3) und mit dem einen Eingang eines ersten Multiplizierers (4) verbunden ist, daß der Ausgang des Vektoridentifizierers (3) mit dem einen Eingang eines zweiten Multiplizierers (7) verbunden ist, daß der Ausgang des Frequenz-Spannungs-Umsetzers (2) über je einen einstellbaren Funktionsgenerator (5, 6), der jeweils den Phasenverschiebungen der Ausgangsgrößen ($A_3$, $A_1$) des Vektoridentifizierers (3) und des Tiefpaß-Filters (1) entsprechende Gleichspannungsgrößen ($P_5$, $P_6$) abgibt, an jeweils den anderen Eingang der beiden Multiplizierer geführt ist und daß die Ausgänge beider Multiplizierer (4, 7) jeweils mit den beiden Eingängen eines Summiergliedes (8) verbunden sind, dessen Ausgang ein die Ausgangsgröße (A) lieferndes Anpassungsglied (9) nachgeordnet ist.

2. Schaltung nach Anspruch 1, dadurch gekennzeichnet, daß der Tiefpaß-Filter (1) ein Tiefpaß-Filter höherer Ordnung ist.

3. Schaltung nach Anspruch 1, dadurch gekennzeichnet, daß als Anpassungsglied (9) ein Proportionalglied vorgesehen ist.

## Claims

1. A circuit for the conversion of an input signal (E) containing harmonics within a specific frequency range into a phase and/or amplitude adjustable sinusoidal output signal, characterised in that the input signal (E) is fed to a conventional low-pass filter (1) connected at the output end to the inputs of a frequency-voltage converter (2) of a phase-shifting vector identifier (3) and to the one input of a first multiplier (4), that the output of the vector identifier (3) is connected to the one input of a second multiplier (7), that the output of the frequency-voltage converter (2) is respectively led to the other input of the two multipliers by means of an adjustable function generator (5, 6) which transmits direct voltage levels ($P_5$, $P_6$) which respectively correspond to the phase shifts of the output signals ($A_3$, $A_1$) of the vector identifier (3) and of the low-pass filter (1), and that the outputs of the two multipliers (4, 7) are respectively connected to the two inputs of a summation element (8), whose output is followed by a matching element (9) supplying the output signal (A).

2. A circuit as claimed in Claim 1, characterised in that the low-pass filter (1) is a low-pass filter of a higher magnitude.

3. A circuit as claimed in Claim 1, characterised in that a proportional element is provided as a matching element (9).

## Revendications

1. Circuit pour transformer une grandeur d'entrée (E) contenant des harmoniques à l'intérieur d'une plage déterminée de fréquences, en une grandeur sinusoïdale de sortie (A) pouvant être réglée du point de vue de la phase et/ou de l'amplitude, caractérisé par le fait que la grandeur d'entrée (E) est envoyée à un filtre passe-bas usuel (1) qui est relié, du côté sortie, aux entrées d'un convertisseur fréquence-tension (2), d'un identificateur vectoriel (3) réalisant un déphasage et à une entrée d'un premier multiplicateur (4), que la sortie de l'identificateur vectoriel (3) est reliée à une entrée d'un second multiplicateur (7), que la sortie du convertisseur de fréquence-tension (2) est raccordée à l'autre entrée respective des deux multiplicateurs par l'intermédiaire de générateurs de fonctions réglables respectifs (5, 6), qui délivrent des grandeurs de tensions continues ($P_5$, $P_6$) correspondant aux déphasages respectifs des grandeurs de sortie ($A_3$, $A_1$) de l'identificateur vectoriel (3) et du filtre passe-bas (1), et que les sorties des deux multiplicateurs (4, 7) sont reliées respectivement aux deux entrées d'un dispositif de sommation (8), en aval de la sortie duquel est branché un organe d'adaptation (9) délivrant la grandeur de sortie (A).

2. Circuit suivant la revendication 1, caractérisé par le fait que le filtre passe-bas (1) est un filtre passe-bas d'ordre supérieur.

3. Circuit suivant la revendication 1, caractérisé par le fait qu'il est prévu comme organe d'adaptation (9) un circuit de transfert à action proportionnelle.

0 060 325

FIG 1

FIG 2

FIG 3

FIG 4

FIG 5